# EUROPEAN PATENT APPLICATION

(11) **EP 4 009 385 A1**
(43) Date of publication of application: **08.06.2022**
(21) Application number: 19940213.2
(22) Date of filing: 26.12.2019
(51) Int. Cl.: H01L 31/18

(54) **FABRICATION METHOD FOR PHOTOVOLTAIC ASSEMBLY**

(30) Priority: 02.08.2019 CN 201910711983
(71) Applicant: ZHEJIANG JINKO SOLAR CO., LTD., Haining, Zhejiang 314416 (CN); JINKO SOLAR CO., LTD., ShangRao, Jiangxi 334100 (CN)
(72) Inventor: GUO, Zhiqiu, Haining, Zhejiang 314416 (CN); WANG, Juan, Haining, Zhejiang 314416 (CN); JIN, Yeyi, Haining, Zhejiang 314416 (CN)
(74) Representative: Piticco, Lorena
(86) International application number: PCT/CN2019/128528
(87) International publication number: WO 2021/022771

(57) **Abstract**

A fabrication method for a photovoltaic assembly, comprising: providing a battery piece having a predetermined thickness, and cutting the battery piece along a direction parallel to the main grid of the battery piece so as to form a cutting line on the surface of the battery piece; breaking the battery piece along the cutting line so as to obtain a plurality of small battery pieces; coating the main grid at the position of the edge of each small battery piece with a conductive adhesive material; overlapping the plurality of small battery pieces in a preset overlapping mode, and curing the conductive adhesive material between the small battery pieces to form a battery string; and packaging the battery string to obtain the photovoltaic assembly. In the foregoing technical solution provided by the present application, the battery piece is not coated with the conductive adhesive material before breaking into pieces, and therefore, if a problem occurs in a device in the process of breaking into pieces or after breaking into pieces, the recycling of the small battery pieces can be realized, so that the waste of the small battery piece is reduced, and the waste of the conductive adhesive material can be reduced, and thus, the fabrication costs of the photovoltaic assembly can be reduced.

## Description

This application claims priority to Chinese Patent Application No. 201910711983.2, titled "FABRICATION METHOD FOR PHOTOVOLTAIC ASSEMBLY", filed on August 2, 2019 with the China National Intellectual Property Administration (CNIPA), which is incorporated herein by reference in its entirety.

### FIELD

The present disclosure relates to the technical field of photovoltaic module fabrication, and in particular to a method for fabricating a photovoltaic module.

### BACKGROUND

With the continuous development of solar cell technology, an extensive attention is paid to a shingled photovoltaic module in which cells are connected in a form of shingles, have no spacing, and have no solder strips shielded on surfaces of the cells. Under a same size, a larger number of cells can be placed in the shingled photovoltaic module. Therefore, the shingled photovoltaic module enables an increased light-receiving area of a photovoltaic module and an increased power generation of the photovoltaic module.

In the conventional technology, the shingled photovoltaic module may be fabricated by: cutting an entire cell sheet to form cutting lines on the cell sheet; printing a conductive adhesive material on busbars of the entire cell sheet; splitting the cell sheet along the cutting lines to obtain cell pieces having the conductive adhesive material; arranging the cell pieces in an overlapping manner and curing the cell pieces to obtain a cell string; encapsulating the cell string to obtain a shingled photovoltaic module. The conductive adhesive material may lose viscosity after being placed for a period of time. Therefore, in the above process, if an equipment failure occurs during or after splitting the cell sheet, a cell piece printed with the conductive adhesive material cannot be recycled, resulting in waste of the cell piece and the conductive adhesive material, which in turn increases a cost for fabricating the shingled photovoltaic module.

Therefore, how to reduce the waste of a cell piece and conductive adhesive material during a process of fabricating a photovoltaic module, so as to reduce the cost for fabricating the photovoltaic module, is a technical problem to be solved urgently by those skilled in the art.

### SUMMARY

In view of the above, an objective of the present disclosure is to provide a method for fabricating a photovoltaic module, with which waste of cell pieces and waste of conductive adhesive material during fabrication of the photovoltaic module may be reduced, and thereby a cost for fabricating the photovoltaic module may be reduced.

To achieve the above objective, technical solutions are provided in the present disclosure as follows.

A method for fabricating a photovoltaic module includes:
providing a cell sheet having a predetermined thickness, and cutting the cell sheet along a direction parallel to busbars of the cell sheet, to form cutting lines on a surface of the cell sheet, where the surface of the cell sheet is printed with a metal pattern including the busbars and fingers;
splitting the cell sheet along the cutting lines, to obtain multiple cell pieces;
coating, for each of the cell pieces, a conductive adhesive material on a busbar located at an edge of the cell piece;
arranging the multiple cell pieces in a preset overlapping manner, where according to the preset overlapping manner, a busbar coated with the conductive adhesive material on a first surface of a first cell piece is overlapped with a busbar on a second surface of a second cell piece adjacent to the first cell piece, and the first surface is opposite to the second surface;
curing the conductive adhesive material among the cell pieces, to form a cell string in which the cell pieces are conductively connected; and
encapsulating the cell string to obtain the photovoltaic module.

In an embodiment, after the splitting the cell sheet along the cutting lines to obtain the multiple cell pieces, the method further includes:
performing, on the cell pieces, any one or more of an efficiency test, an EL test, and a PL test, and grouping cell pieces whose efficiency and/or brightness are at a same level into a same group.

In an embodiment, the cutting the cell sheet along the direction parallel to the busbars of the cell sheet includes:
cutting, by laser scribing or diamond scribing, the cell sheet along the direction parallel to the busbars of the cell sheet.

In an embodiment, the splitting the cell sheet along the cutting lines includes:
splitting the cell sheet by a cell sheet splitting device, where the cell sheet splitting device includes a controller and a splitting component connected with the controller.

In an embodiment, each of the cell pieces includes a first busbar and a second busbar, where for each of the cell pieces,
the first busbar is located within a preset distance from a first long edge of an upper surface of the cell piece,
the second busbar is located within the preset distance from a second long edge of a lower surface of the cell piece, and
the first long edge and the second long edge are parallel and opposite to each other.

In an embodiment, the coating, for each of the cell pieces, the conductive adhesive material on the busbar located at the edge of the cell piece includes:
coating the conductive adhesive material on the first busbar or the second busbar of the cell piece.

In an embodiment, the coating the conductive adhesive material on the first busbar or the second busbar of the cell piece includes:
coating, by dispensing or printing, the conductive adhesive material on the first busbar or the second busbar of the cell piece.

In an embodiment, the cell sheet is in a square shape with chamfered corners, and a side length of the cell sheet is greater than or equal to 156mm.

In an embodiment, each of the fingers is perpendicular or non-perpendicular to the busbars, and each of the fingers is a straight segment or a non-straight segment.

In an embodiment, each of the busbars is one of the following: a through-type busbar, a finger-grouped busbar, and a through-type busbar with a second finger, where:
the finger-grouped busbar includes multiple third fingers parallel to the busbar, and the multiple third fingers are connected by connecting blocks; and
the through-type busbar with the second finger includes the through-type busbar and the second finger parallel to the through-type busbar.

A method for fabricating a photovoltaic module is provided in the present disclosure, and the method includes: providing a cell sheet having a predetermined thickness, and cutting the cell sheet along a direction parallel to busbars of the cell sheet, to form cutting lines on a surface of the cell sheet, where the surface of the cell sheet is printed with a metal pattern comprising the busbars and fingers; splitting the cell sheet along the cutting lines, to obtain multiple cell pieces; coating, for each of the cell pieces, a conductive adhesive material on a busbar located at an edge of the cell piece; arranging the multiple cell pieces in a preset overlapping manner, where according to the preset overlapping manner, a busbar coated with the conductive adhesive material on a first surface of a first cell piece is overlapped with a bus bar on a second surface of a second cell piece adjacent to the first cell piece, and the first surface is opposite to the second surface; curing the conductive adhesive material among the cell pieces, to form a cell string in which the cell pieces are conductively connected; and encapsulating the cell string to obtain the photovoltaic module.

In the technical solution disclosed in the present disclosure, a cell sheet is first cut to obtain multiple cutting lines; then the cell sheet is split along the cutting lines to obtain cell pieces; then the cell pieces are coated with conductive adhesive material, and the cell pieces are arranged in an overlapping manner, and then cured and encapsulated to obtain a photovoltaic module. In the above fabrication process, since the cell sheet has not been coated with the conductive adhesive material before being split into cell pieces, the cell pieces may be recycled if there is an equipment failure during or after splitting the cell sheet, so that waste of the cell pieces may be reduced. In addition, since the cell sheet has not been coated with the conductive adhesive material before being split, waste of the conductive adhesive material may be reduced, and thereby cost for fabricating the photovoltaic module may be reduced.

### BRIEF DESCRIPTION OF THE DRAWINGS

For a clearer illustration of technical solutions in embodiments of the present disclosure or the conventional technology, drawings used in the description of the embodiments or the conventional technology are described briefly hereinafter. Apparently, the drawings described in the following illustrate only some embodiments of the present disclosure, and other drawings may be obtained by those ordinarily skilled in the art based on these drawings without any creative effort.
Figure 1 is a flowchart of a method for fabricating a photovoltaic module according to an embodiment of the present disclosure;
Figure 2 is a schematic diagram showing overlapping of cell pieces according to an embodiment of the present disclosure;
Figure 3 is a schematic structural diagram of a cell string finally obtained according to an embodiment of the present disclosure;
Figure 4 is a schematic structural diagram of a splitting component included in a cell sheet splitting device according to an embodiment of the present disclosure;
Figure 5 is a schematic diagram of a splitting component in action according to an embodiment of the present disclosure;
Figure 6 is a structural diagram of a cell sheet in which a first finger is a straight segment and is perpendicular to busbars according to an embodiment of the present disclosure;
Figure 7 is a structural diagram of a cell sheet in which a first finger is a straight segment but is not perpendicular to busbars according to an embodiment of the present disclosure;
Figure 8 is a structural diagram of a first cell sheet in which a first finger is a non-straight segment according to an embodiment of the present disclosure;
Figure 9 is a structural diagram of a second cell sheet in which a first finger is a non-straight segment according to an embodiment of the present disclosure;
Figure 10 is a structural diagram of a through-type busbar printed on a surface of a silicon wafer according to an embodiment of the disclosure;
Figure 11 is a partial enlarged view of a finger-grouped busbar printed on a surface of a silicon wafer according to an embodiment of the present disclosure; and
Figure 12 is a partial enlarged view of a busbar with a finger printed on a surface of a silicon wafer according to an embodiment of the present disclosure.

### DETAILED DESCRIPTION

Technical solutions of embodiments of the present disclosure are described clearly and completely below in conjunction with the drawings of the embodiments of the present disclosure. Apparently, the embodiments described in the following are only some of rather than all the embodiments of the present disclosure. Any other embodiments obtained by those skilled in the art based on the embodiments in the present disclosure without any creative effort shall fall within the protection scope of the present disclosure.

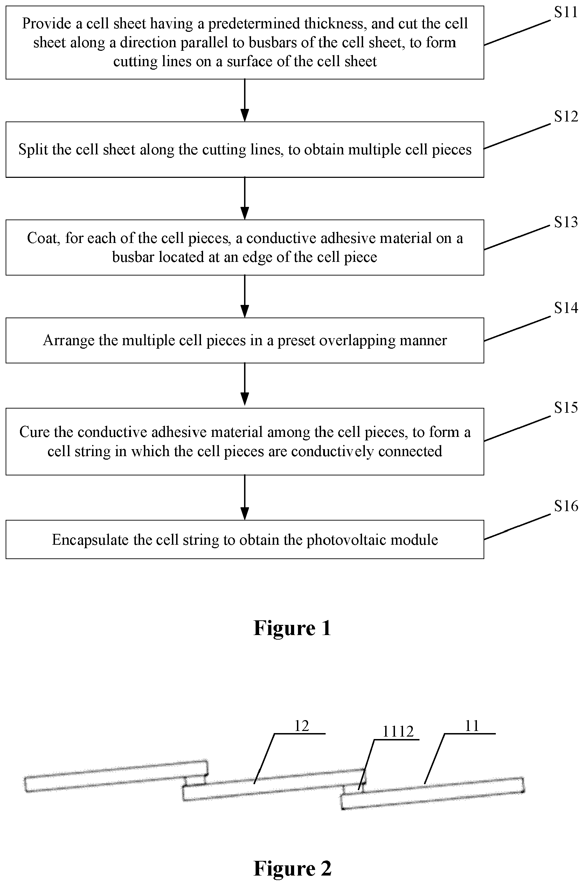

Figure 1 shows a flowchart of a method for fabricating a photovoltaic module according to an embodiment of the present disclosure. Referring to Figure 1, the method may include steps S11 to S16.

In S 11, a cell sheet having a predetermined thickness is provided, and the cell sheet is cut along a direction parallel to busbars of the cell sheet, to obtain cutting lines on a surface of the cell sheet.

The surface of the cell sheet is printed with a metal pattern including the busbars and fingers.

After an entire cell sheet is prepared, an entire cell sheet with a preset thickness may be provided. The surface of the cell sheet is printed with a metal pattern. The metal pattern serves as wires for conduction. Specifically, the metal pattern includes busbars and fingers. The busbars are printed on both a first surface and a second surface of the cell sheet, and are used to conduct a current generated inside a cell to the outside. The number of busbars printed on the first surface of the cell sheet is equal to the number of busbars printed on the second surface of the cell sheet. In addition, the fingers are printed on the first surface and/or the second surface, and are used to collect an internal current.

After the cell sheet having a preset thickness is provided, cutting positions for the cell sheet may be determined based on a size of a cell piece included in the to-be-fabricated photovoltaic module. Then the cell sheet may be cut along a direction parallel to the busbars of the cell sheet, to form cutting lines on the surface of the cell sheet. The step of cutting the cell sheet along the direction parallel to the busbars of the cell sheet may be specifically as follows. The cell sheet is cut at a position close to the busbars and along the direction parallel to the busbars, and there is no finger between the cutting lines and the busbars, in order to avoid damage to the fingers. Apparently, other methods may be adopted to cut the cell sheet along the direction parallel to the busbars of the cell sheet.

In addition, after the cutting lines are formed, the cell sheet may be divided into several regions by the cutting lines, and each of the regions may correspond to a cell piece. The regions may or may not have equal widths, that is, the finally obtained cell pieces may or may not be equal-sized, which is not limited herein.

In S12, the cell sheet is split along the cutting lines into multiple cell pieces.

After the cutting lines are formed by cutting the cell sheet, the cell sheet with the cutting lines may be transported, by using a clamping jaw or conveyor belt, to a position for a splitting operation. Then, the cell sheet may be split along the cutting lines to obtain multiple cell pieces. Each of the cell pieces is in a rectangular shape or approximately in a rectangular shape. In addition, in a case where the cutting is performed at positions respectively close to the respective busbars of the cell sheet, each of the busbars of the cell sheet may be located at one or two edges of a surface of each cell piece after cutting and splitting the cell sheet; and in a case where the cutting is performed at positions respectively close to only part of the busbars of the cell sheet, the busbar may be not only located at an edge of a cell piece but also located within the edge of the cell piece after cutting and splitting the cell sheet. The busbar located at an edge of a cell piece may be within 2mm from the edge of the cell piece.

In a process of obtaining cell pieces, the cutting lines may not only function for identification and division of the regions, but also reduce a force applied for splitting the cell sheet, so as to facilitate the splitting operation on the cell sheet.

In S13, a conductive adhesive material is coated, for each of the cell pieces, on a busbar at an edge of the cell piece.

After the cell pieces are obtained, a conductive adhesive material may be coated on the busbar at an edge of each of the cell pieces, so that the cell pieces may be connected by means of the conductive adhesive material coated on the busbars at edges of the cell pieces. The conductive adhesive material here may specifically be a material having both conductivity and adhesiveness, such as electrically conductive adhesive.

In S14, the multiple cell pieces are arranged in a preset overlapping manner.

According to the preset overlapping manner, a busbar coated with the conductive adhesive material on a first surface of a first cell piece is overlapped with a busbar on a second surface of a second cell piece adjacent to the first cell piece. The first surface is opposite to the second surface.

After the conductive adhesive material is coated, the cell pieces coated with the conductive adhesive material are grasped by a mechanical grasping mechanism and transported from a place (referred to as a first platform) for coating the conductive adhesive material to a place (referred to as a second platform) for overlapping, in order to arrange the cell pieces in the preset overlapping manner.

Reference is made to Figure 2 which is a schematic diagram showing overlapping of cell pieces according to an embodiment of the present disclosure. The cell pieces are arranged under the present overlapping manner as following. A first cell piece 11 is disposed on the second platform, and a side (left edge) with the conductive adhesive material 1112 on a first surface (the first surface here refers to an upper surface) of the first cell piece 11 is placed close to the first platform. Then, a second cell piece 12 is grasped by using a mechanical grasping mechanism and transported from the first platform to the second platform, and a side (right edge) on a second surface (correspondingly, the second surface here refers to a lower surface) of the second cell piece 12 is placed overlapping with the side with the conductive adhesive material 1112 on the first surface of the first cell piece 11, so that the side with the conductive adhesive material 1112 on the first surface of the first cell piece 11 is connected with the side on the second surface of the second cell piece 12 through the conductive adhesive material 1112, realizing a serial connection between the first cell piece 11 and the second cell piece 12.

Figure 2 shows three cell pieces as an example for illustration. A larger number of cell pieces may be arranged similarly as the overlapping manner in Figure 2. During overlapping of the cell pieces, the first surface of the first cell piece 11 is opposite to the second surface of the second cell piece 12 (that is, in a case where the first surface is an upper surface of the cell piece, the second surface is a lower surface of the cell piece; and in a case where the first surface is a lower surface of the cell piece, the second surface is an upper surface of the cell piece); and a side (i.e., a first side) with the conductive adhesive material 1112 on the first surface of the first cell piece 11 is opposite to a side (i.e. a second side) of the second surface of the second cell piece 12 (that is, in a case where the first side is a left edge, the second side is a right edge; and in a case where the first side is a right edge, the second side is a left edge). In this way, a serial connection among the cell pieces is realized.

In S15, the conductive adhesive material between the cell pieces is cured to form a cell string in which the cell pieces are conductively connected.

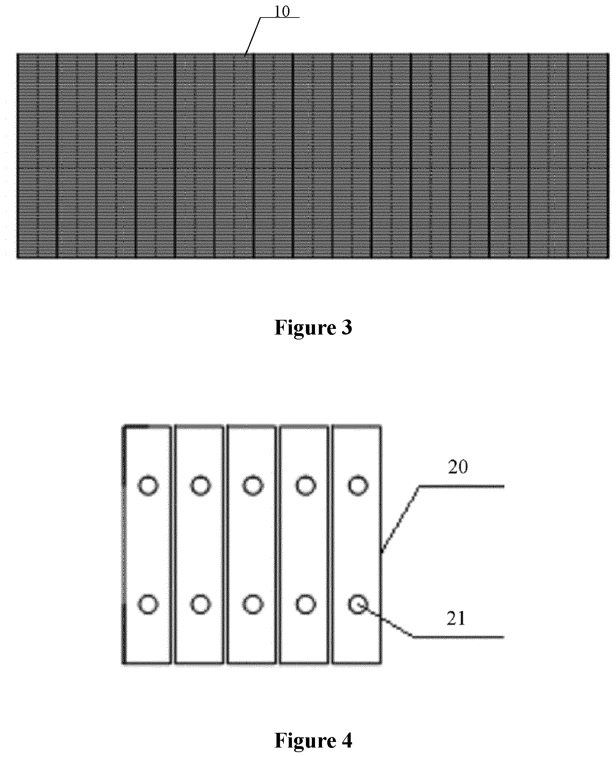

Reference is made to Figure 3 which is a schematic structural diagram of a cell string finally obtained according to an embodiment of the present disclosure. After the cell pieces 10 are arranged in an overlapping manner, the conductive adhesive material coated on the cell pieces 10 is cured, so that the cell pieces 10 may be connected together by means of the conductive adhesive material (that is, the cell pieces 10 are electrically connected by means of the cured conductive adhesive material), to finally obtain a cell string.

It should be noted that, to facilitate a smooth overlapping of the cell pieces, there has to be a busbar at each of a first edge position (which is specifically a position parallel to the busbar) on the first surface of each cell piece and a second edge position (which is specifically a position parallel to the busbars) on the second surface of each cell piece. The first edge position and the second edge position are opposite to each other.

In S16, the cell string is encapsulated to obtain a photovoltaic module.

The cell string is encapsulated with an encapsulation material, such as glass and adhesive film, to obtain the photovoltaic module.

In the above technical solution disclosed in the present disclosure, a cell sheet is first cut to obtain multiple cutting lines; then the cell sheet is split along the cutting lines to obtain cell pieces; then the cell pieces are coated with conductive adhesive material, and the cell pieces are arranged in an overlapping manner, and then cured and encapsulated to obtain a photovoltaic module. In the above fabrication process, since the cell sheet has not been coated with the conductive adhesive material before being split into cell pieces, the cell pieces may be recycled if there is an equipment failure during or after splitting the cell sheet, so that waste of the cell pieces may be reduced. In addition, since the cell sheet has not been coated with the conductive adhesive material before being split, waste of the conductive adhesive material may be reduced, and thereby cost for fabricating the photovoltaic module may be reduced.

In the method for fabricating a photovoltaic module according to an embodiment of the present disclosure, after the step of splitting the cell sheet along the cutting lines to obtain multiple cell pieces, the method may further include the following step.

Any one or more of an efficiency test, an EL test, and a PL test are performed on the cell pieces, and cell pieces whose efficiency and/or brightness are at a same level are grouped into a same group

Considering a problem of uneven efficiency distribution (which lead to uneven brightness) in the cell sheet itself and a problem of uneven efficiency among finally obtained cell pieces due to cutting loss in the cutting operation on the cell sheet, the cell pieces having uneven efficiency being disposed in a same cell string and a same photovoltaic module may result in that: the photovoltaic module needs to be repaired due to efficiency difference, which increases the labor and time, resulting in an increased cost; and an output power of the photovoltaic module may be reduced due to a current/voltage mismatch of the photovoltaic module caused by the efficiency difference. Therefore, any one or more of an efficiency test, an EL test, and a PL test may be performed to sort the cell pieces, in order to avoid the efficiency difference among the cell pieces in a same cell string and a same photovoltaic module, so as to reduce a repair rate of the photovoltaic module, reduce the current/voltage mismatch of the photovoltaic module, and thereby save labor, reduce cost, and improve the output power of the photovoltaic module.

Specifically, considering that there is no conductive adhesive material on the cell pieces obtained after splitting the cell sheet, the cell pieces may be sorted in the following manner after splitting the cell sheet. After multiple cell pieces are obtained by splitting the cell sheet along the cutting lines, any one or more of an efficiency test, an EL test, and a PL test are performed on the cell pieces, and then the cell pieces whose efficiency and/or brightness are at a same level are grouped into a same group. In the expression "efficiency and/or brightness", "and" means that the efficiency test and at least one of the EL test and the PL test are performed; while "or" means that either the efficiency test corresponding to efficiency is performed, or at least one of the EL test and the PL test corresponding to brightness is performed. In this way, the cell pieces in a same group may be directly used for gluing, overlapping and encapsulating in subsequent processes, so as to obtain a photovoltaic module in which the cell pieces have efficiencies at a same level, reducing the efficiency difference among the cell pieces in the photovoltaic module.

The level mentioned above may be set in advance (before the test) or after the test based on the efficiency and/or brightness of each of the cell pieces and the efficiency difference that the cell string and the photovoltaic module can tolerate, in order to sort the cell pieces with less efficiency difference into a same group, and sort the cells pieces with obvious efficiency difference into different groups, so as to avoid the efficiency difference among the cell pieces in a same cell string and a same photovoltaic module as much as possible, thereby reducing the repair rate of the photovoltaic module, reducing the current/voltage mismatch of the photovoltaic module, hence saving labor, reducing costs, and improving the output power of the photovoltaic module.

In addition, the EL test and the PL test may also help timely find and exclude the cell pieces with defects such as cracks, so as to avoid using such cell pieces in fabricating a photovoltaic module, thereby improving performance of the fabricated photovoltaic module.

In the method for fabricating a photovoltaic module according to an embodiment of the present disclosure, the step of cutting the cell sheet along a direction parallel to busbars of the cell sheet may include:
cutting, by laser scribing or diamond scribing, the cell sheet along the direction parallel to the busbars of the cell sheet.

The cell sheet may be cut, by laser scribing or diamond scribing, along the direction parallel to the busbars of the cell sheet, so as to improve a cutting rate and reduce damage to the cell sheet.

In the method for fabricating a photovoltaic module according to an embodiment of the present disclosure, the step of splitting the cell sheet along the cutting lines may include:
splitting the cell sheet by a cell sheet splitting device.

The cell sheet splitting device may include a controller and a splitting component connected with the controller.

A cell sheet splitting device may be used to split the cell sheet, so as to improve a rate in splitting the cell sheet and improve efficiency in fabricating the photovoltaic module.

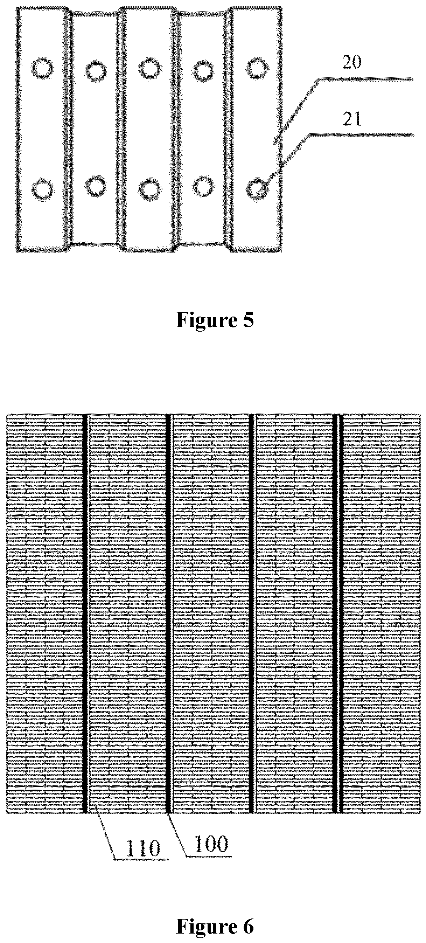

Reference is made to Figure 4 and Figure 5. Figure 4 is a schematic structural diagram of a splitting component included in a cell sheet splitting device according to an embodiment of the present disclosure, and Figure 5 is a schematic diagram of a splitting component in action according to an embodiment of the present disclosure. The cell sheet splitting device may include a controller and several splitting components 20 connected to the controller. The number of the splitting components 20 is equal to the number of regions divided by the cutting lines. Two or other numbers of adsorption holes 21 are provided on each of the splitting components 20. During splitting of the cell sheet, the splitting components 20 are adsorbed on different regions of the cell sheet by means of the adsorption holes 21 under the control of the controller, and then the splitting components 20 move downward or upward under the control of the controller (see Figure 5). In this way, the cell sheet is split, due to an action of force, into cell pieces along the cutting lines.

In the method for fabricating a photovoltaic module according to an embodiment of the present disclosure, each of the cell pieces may include a first busbar and a second busbar.

For each of the cell pieces, the first busbar is located within a preset distance from a first long edge of an upper surface of the cell piece, and the second busbar is located within a preset distance from a second long edge of a lower surface of the cell piece. The first long edge and the second long edge are parallel and opposite to each other.

Since the busbar is printed on each of an upper surface and a lower surface of the cell sheet, each of the cell pieces obtained by cutting and splitting may include a first busbar and a second busbar. The first busbar is located within a preset distance from the first long edge of the upper surface of the cell piece, and the second busbar is located within the preset distance from the second long edge of the lower surface of the cell piece. The preset distance may be 2mm or adjusted as needed. The first long edge and the second long edge are parallel and opposite to each other, so that the cell pieces are overlapped through the first busbar and the second busbar.

In the method for fabricating a photovoltaic module according to an embodiment of the present disclosure, the step of coating, for each of the cell pieces, a conductive adhesive material on a busbar located at an edge of the cell piece may include:
coating the conductive adhesive material on the first busbar or the second busbar of the cell piece.

To realize overlapping of the cell pieces, it is only necessary to connect the first busbar on the first surface of the first cell piece with the second busbar on the second surface of the second cell piece. Therefore, in order to avoid waste of the conductive adhesive material, and in order to avoid any effect on power generation of the photovoltaic module due to the conductive adhesive material coated at unnecessary position, the conductive adhesive material may be simply coated on the first busbar of the cell piece or the second busbar of the cell piece, so that the cell piece can be overlapped with other cell piece.

In the method for fabricating a photovoltaic module according to an embodiment of the present disclosure, the step of coating the conductive adhesive material on the first busbar or the second busbar of the cell piece may include:
coating, by dispensing or printing, the conductive adhesive material on the first busbar or the second busbar of the cell piece.

The conductive adhesive material may be coated on the first busbar or the second busbar of a cell piece by dispensing or printing, so that the conductive adhesive material can be distributed as accurately as possible on the busbar at an edge of the cell piece.

In the method for fabricating a photovoltaic module according to an embodiment of the present disclosure, the cell sheet is in a square shape with chamfered corners, and a side length of the cell sheet is greater than or equal to 156mm.

In the present disclosure, the cell sheet may be specifically in a square shape with chamfered corners, and a side length of the cell sheet may be greater than or equal to 156mm, so as to facilitate acquisition of cell pieces from the cell sheet. In the cell sheet in a square shape with chamfered corners, four corners of the cell sheet are all in a chamfered structure. The size of the chamfered structure may be 2mm, 5mm, 10mm or the like, which is not limited in the present disclosure.

Apparently, the cell pieces may be obtained from the cell sheet in a square shape with chamfered corners having another side length, and the size of the cell sheet is not limited in the present disclosure.

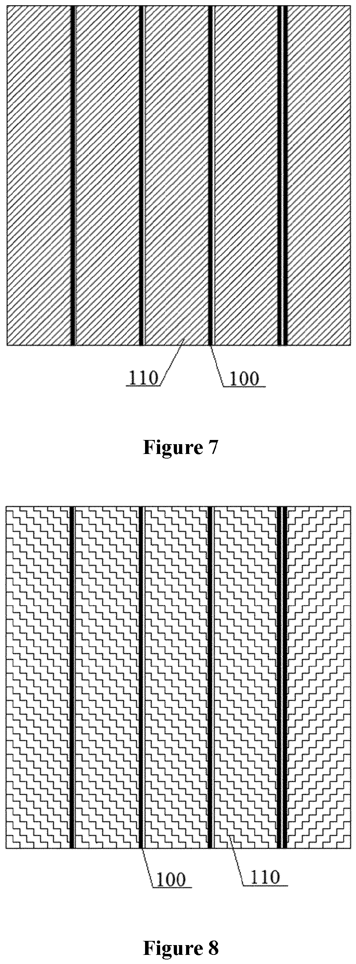

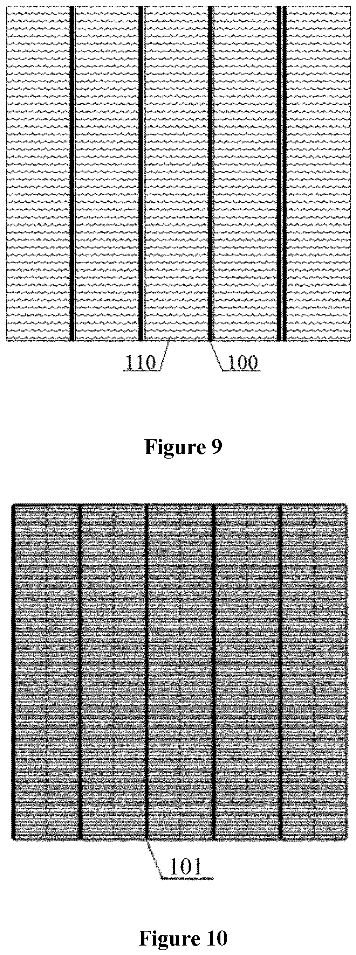

Reference may be made to Figure 6 to Figure 9. Figure 6 is a structural diagram of a cell sheet in which a first finger is a straight segment and is perpendicular to busbars according to an embodiment of the present disclosure, Figure 7 is a structural diagram of a cell sheet in which a first finger is a straight segment but is not perpendicular to busbars according to an embodiment of the present disclosure, Figure 8 is a structural diagram of a first cell sheet in which a first finger is a non-straight segment according to an embodiment of the present disclosure, and Figure 9 is a structural diagram of a second cell sheet in which a first finger is a non-straight segment according to an embodiment of the present disclosure. In the method for fabricating a photovoltaic module according to an embodiment of the present disclosure, a finger is perpendicular or non-perpendicular to busbars, and the finger is a straight segment or non-straight segment.

The busbars 100 are provided on both of the first surface and the second surface of the cell sheet, and the fingers 110 are provided on the first surface and/or the second surface of the cell sheet. In a case where the fingers 110 are provided on both of the first surface and the second surface, the cell sheet can generate electricity on both sides, and the cell sheet may be referred to as a double-sided cell sheet. In a case where the fingers 110 are printed on the first surface or the second surface, the cell sheet can generate electricity on one side, and the cell sheet may be referred to as a single-sided cell sheet.

Each of the fingers 110 may be in a form of a straight segment, and the fingers 110 each being a straight segment may be perpendicular to the busbars 100 (see Figure 6), or may not be perpendicular to the busbars 100 (see Figure 7). In addition, each of the fingers 110 may be in a form of a non-straight segment (see Figure 8 and Figure 9). The cell sheet mentioned with reference to Figure 6 to Figure 9 may be a single-sided cell sheet or a double-sided cell sheet, which is not limited in the present disclosure.

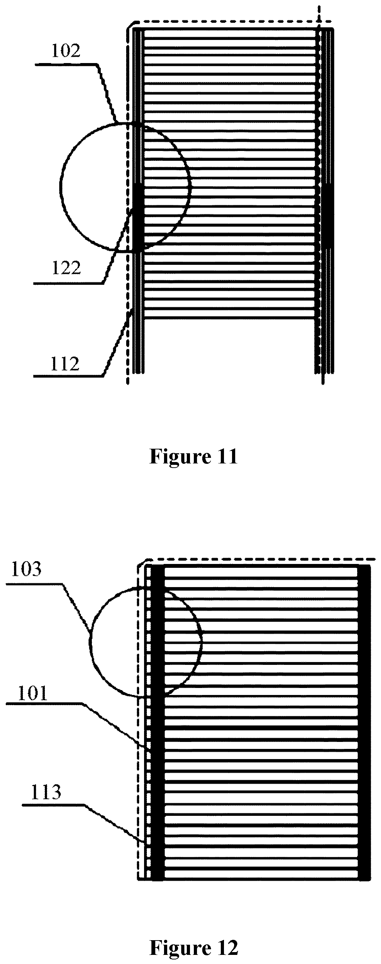

Reference may be made to Figure 10 to Figure 12. Figure 10 is a structural diagram of a through-type busbar printed on a surface of a silicon wafer according to an embodiment of the present disclosure, Figure 11 is a partial enlarged view of a finger-grouped busbar printed on a surface of a silicon wafer according to an embodiment of the present disclosure, and Figure 12 is a partial enlarged view of a busbar with a finger printed on a surface of a silicon wafer according to an embodiment of the present disclosure. In the method for fabricating a photovoltaic module according to an embodiment of the present disclosure, each of the busbars 101 is one of the following: a through-type busbar 101, a finger-grouped busbar 102, and a through-type busbar 103 with a second finger.

The finger-grouped busbar 102 includes multiple third fingers 112 parallel to the busbars 100, and the multiple third fingers 112 are connected by connecting blocks.

The through-type busbar 103 with a second finger includes the through-type busbar 101 and a second finger 113 parallel to the through-type busbar 101.

Each of the busbars 100 included on the surface of the cell sheet may be any of the following: a straight-through busbar 101 (see Figure 10 for details), a finger-grouped busbar 102 (see Figure 11 for details), and a through-type busbar 103 with a second finger (see Figure 12 for details). The finger-grouped busbar 102 includes multiple second fingers 112 parallel to the busbars 100, and the multiple second fingers 112 are connected by connecting blocks 122. The through-type busbar 103 with a second finger includes the through-type busbar 101 and a second finger 113 parallel to the through-type busbar 101, and the second finger 113 is located on an outer side of the through-type busbar 101. Each of the busbars 100 in any of the mentioned type can conduct a current from the cell sheet to the outside, so as to realize power generation. Apparently, segmented busbars (which are specifically multiple contact points parallel to an edge) or graded busbars may also be used as the busbars 100 of the cell sheet.

The busbars 100 may be uniformly or non-uniformly distributed on the surface of the cell sheet. In addition, two edges of the first surface of the cell sheet and two edges of the second surface of the cell sheet may be all printed with the busbars 100; or none of the two edges of the first surface of the cell sheet or the two edges of the second surface of the cell sheet is printed with the busbars 100; or one of the two edges of the first surface of the cell sheet and one of the two edges of the second surface of the cell sheet may be both printed with the busbars 100. In other words, an edge of a surface of the cell sheet may or may not be printed with the busbars 100.

It should be noted that the relationship terms such as "first", "second" and the like are used herein merely to distinguish one entity or operation from another, rather than to necessitate or imply existence of an actual relationship or order of the entities or operations. Moreover, terms "include", "comprise" or any other variants thereof are intended to be non-exclusive. Therefore, a process, method, article or device including a series of elements further includes elements that are inherent to the process, method, article or device. Unless expressively limited otherwise, a process, method, article or device limited by "comprising/including a(n) ..." does not exclude existence of another identical element in such process, method, article or device. Besides, parts of the technical solutions in the embodiments of the present disclosure that are consistent with the implementation principles of corresponding technical solutions in the conventional technology are not described in detail, so as to avoid redundant description.

The above description of the disclosed embodiments enables those skilled in the art to implement or practice the present disclosure. Various modifications to these embodiments are obvious to those skilled in the art. The general principles defined in the present disclosure may be implemented in other embodiments without departing from the spirit and scope of the present disclosure. Therefore, the present disclosure should not be limited to the embodiments disclosed herein, but conforms to the widest scope consistent with the principle and novel features disclosed in the specification.

## Claims

1. A method for fabricating a photovoltaic module, comprising:
providing a cell sheet having a predetermined thickness, and cutting the cell sheet along a direction parallel to busbars of the cell sheet, to form cutting lines on a surface of the cell sheet, wherein the surface of the cell sheet is printed with a metal pattern comprising the busbars and fingers;
splitting the cell sheet along the cutting lines, to obtain a plurality of cell pieces;
coating, for each of the cell pieces, a conductive adhesive material on a busbar located at an edge of the cell piece;
arranging the plurality of cell pieces in a preset overlapping manner, wherein according to the preset overlapping manner, a busbar coated with the conductive adhesive material on a first surface of a first cell piece is overlapped with a busbar on a second surface of a second cell piece adjacent to the first cell piece, wherein the first surface is opposite to the second surface;
curing the conductive adhesive material among the cell pieces, to form a cell string in which the cell pieces are conductively connected; and
encapsulating the cell string to obtain the photovoltaic module.

2. The method for fabricating a photovoltaic module according to claim 1, wherein after the splitting the cell sheet along the cutting lines to obtain the plurality of cell pieces, the method further comprises:
performing, on the cell pieces, any one or more of an efficiency test, an EL test, and a PL test, and grouping cell pieces whose efficiency and/or brightness are at a same level into a same group.

3. The method for fabricating a photovoltaic module according to claim 1, wherein the cutting the cell sheet along the direction parallel to the busbars of the cell sheet comprises:
cutting, by laser scribing or diamond scribing, the cell sheet along the direction parallel to the busbars of the cell sheet.

4. The method for fabricating a photovoltaic module according to claim 1, wherein the splitting the cell sheet along the cutting lines comprises:
splitting the cell sheet by a cell sheet splitting device, wherein the cell sheet splitting device comprises a controller and a splitting component connected with the controller.

5. The method for fabricating a photovoltaic module according to claim 1, wherein each of the cell pieces comprises a first busbar and a second busbar, wherein
for each of the cell pieces,
the first busbar is located within a preset distance from a first long edge of an upper surface of the cell piece,
the second busbar is located within the preset distance from a second long edge of a lower surface of the cell piece, and
the first long edge and the second long edge are parallel and opposite to each other.

6. The method for fabricating a photovoltaic module according to claim 5, wherein the coating, for each of the cell pieces, the conductive adhesive material on the busbar located at the edge of the cell piece comprises:
coating the conductive adhesive material on the first busbar or the second busbar of the cell piece.

7. The method for fabricating a photovoltaic module according to claim 6, wherein the coating the conductive adhesive material on the first busbar or the second busbar of the cell piece comprises:
coating, by dispensing or printing, the conductive adhesive material on the first busbar or the second busbar of the cell piece.

8. The method for fabricating a photovoltaic module according to claim 1, wherein the cell sheet is in a square shape with chamfered corners, and a side length of the cell sheet is greater than or equal to 156mm.

9. The method for fabricating a photovoltaic module according to claim 1, wherein each of the fingers is perpendicular or non-perpendicular to the busbars, and each of the fingers is a straight segment or a non-straight segment.

10. The method for fabricating a photovoltaic module according to any one of claims 1 to 9, wherein each of the busbars is one of the following: a through-type busbar, a finger-grouped busbar, and a through-type busbar with a second finger, wherein
the finger-grouped busbar comprises a plurality of third fingers parallel to the busbar, and the plurality of third fingers are connected by connecting blocks; and
the through-type busbar with the second finger comprises the through-type busbar and the second finger parallel to the through-type busbar.
